# EUROPEAN PATENT APPLICATION

(11) **EP 3 171 680 A1**
(43) Date of publication of application: **24.05.2017**
(21) Application number: 16199863.8
(22) Date of filing: 21.11.2016
(51) Int. Cl.: H05K 1/14, H05K 1/02, G06F 1/20

(54) **MEZZANINE FILLER MODULE APPARATUSES AND METHODS FOR COMPUTING DEVICES**

(30) Priority: 23.11.2015 US 201514949075
(71) Applicant: General Electric Company, Schenectady, NY 12345 (US)
(72) Inventor: SLATON, David S, Huntsville, AL 35803 (US); WRIGHT, Jerry Leon, Huntsville, AL 35803 (US); HODEN, Brian Patrick, Huntsville, AL 35803 (US)
(74) Representative: Illingworth-Law, William Illingworth

(57) **Abstract**

Disclosed herein are systems and methods for the thermal regulation of on-board electronic components (106) using a mezzanine filler module (104). The mezzanine filler module (104) connects at a mezzanine site (102) of the circuit board (108) to provide an additional thermal conduction path for thermal energy released, at least, from component located under the mezzanine site (102).

## Description

### FIELD OF THE DISCLOSURE

Embodiments of the disclosure generally relate to a computing component, and more particularly, to a mezzanine filler module apparatuses and methods for computing devices.

### BACKGROUND

One type of single board computers employs computing form format standards that offer, as a feature, one or more expansion sites to accept mezzanine cards. These mezzanine cards are smaller form factor cards that are, in many instances, also manufactured to a standard and are configured to stack onto a carrier card such as a single board computer to add or enhance the computing and/or peripheral capabilities of the carrier card. The sites on the single board computer to accept the mezzanine cards are often referred to as mezzanine sites. The mezzanine cards couple to the carrier board through a connector that includes connections to the data bus of the carrier board, as well as connections for IO connectivity, power, and ground. Mezzanine cards are often labeled according to the data bus type to which they connect. IEEEP1386.1, for example, defines the standard for Mezzanine cards with a peripheral component interconnect (PCI) databus. Other standards are available for Versa Module Europa (VME) bus, PCI-express (PCIe) bus, as a further example. Mezzanine cards are also referred to as daughter-cards, daughter-boards, and piggyback boards.

Because of their compact and/or rugged configuration, single board computers are used in a wide number of computing and control applications, particularly in industrial, telecommunication, aerospace, and military systems. However, because of their compact form factor, thermal regulation of computing components poses a challenge to system designers that uses single board computers in such applications. Though active thermal regulation systems are available, passive conduction and convection thermal regulation systems are often preferred for their simplicity and robustness in many applications. And, as the requirements for processing density, functionality, and compactness of computing systems have increased over time for embedded control systems, greater heat dissipation capability is needed.

Therefore, what are needed are devices, systems and methods that overcome challenges in the present art, some of which are described above.

### SUMMARY

Disclosed herein are mezzanine form-factor apparatuses and methods for the thermal regulation of electronic components of computing device with mezzanine sites. The mezzanine-based apparatus, as a filler module, beneficially serves as an additional heat path for on-board components under a mezzanine site of a computing system, allowing for the accommodation of higher power usage on the computing system and/or daughterboard attached thereto.

Exemplified herein is a mezzanine-based filler module that is configured as a PMC orXMC module. The dimensions of the filler module conforms to that of a standard module (e.g., PMC or XMC) to allow, in some embodiments, interoperability of the mezzanine-based filler module with any standard compliant computing device. PMC refers to a mezzanine card with a PCI databus and XMC refers to a mezzanine card with a PCIe (namely, PCI Express) databus. Other types of applicable standards include, but are not limited to, Processor PMC (PPMC or PrPMC) and conduction-cooled PMC (CCPMC).

In one aspect, a system for the regulation of device temperature is described. The system includes a circuit board (e.g., a printed circuit board such as a carrier card or single board computer) having one or more mezzanine sites where each site includes an area on the PCB designated for a second circuit board (e.g., a printed circuit board) such that the second circuit board overlays one or more components of the plurality of heat producing components of the first circuit board. The circuit board includes one or more mounting members (e.g., for coupling to the second circuit board), where each of the one or more mounting members (e.g., standoffs, spacers, DIN connectors) is associated with a mezzanine site of the one or more mezzanine sites. The system further includes a filler module (e.g., a standardized non-system specific filler module) configured to connect to the circuit board at one of the one or more mezzanine sites. The filler module, in some embodiments, includes a second mounting member removably attachable to one of the one or more mounting members of the circuit board.

In some embodiments, the filler module includes a base structure having a surface proximately positionable with respect to one of one or more heat producing components of the circuit board so as to form a thermal conduction path therewith (e.g., i) direct thermal contact between the filler module and ICs on the PCB, or ii) across a thermal interface material applied between the one of one or more heat producing components of the circuit board and the base structure of the filler module).

In some embodiments, the base structure of the filler module includes a thermal contact surface spanning an overlaid portion of the filler module over the circuit board, the contact surface being proximately positionable to a plurality of circuit board of a plurality of module computing devices (e.g., single board computer), including a first computing device and a second computing device, the first computing device having a first set of plurality of heat producing components at a first placement configuration on the circuit board thereof, and the second computing device having a second set of plurality of heat producing components at a second placement configuration on the circuit board thereof, wherein the first placement configuration is different from the second placement configuration.

In some embodiments, the base structure of the filler module is proximal, when in the assembled configuration with a given circuit board, to only heat-producing components of the given circuit board so as to only form a thermal conduction path therewith (e.g., wherein the filler module generates no heat therein, e.g., does not include a CPU, memory module).

In some embodiments the filler module includes corresponding mounting members removably connectable with the one or more mounting members of the circuit board (e.g., wherein the mounting members of the filler module are either i) fixably connected to the base structure of the filler module or ii) fixably connected to a circuit board of the filler module, the circuit board of the filler module being fixably coupled to the base structure of the filler module).

In some embodiments, the system further includes a thermal interface material (TIM) applied between two or more the at least one heat producing component and the filler module so as to form direct thermal contact therebetween. In some embodiments the thermal interface material is selected based on a contact pressure property, an electrical resistivity property, and/or a dielectric strength property. In some embodiments, the thermal interface material comprises thermal grease, e.g., epoxy, a silicone, a urethane, and an acrylate. In some embodiments, the thermal interface material includes a material selected a solvent-based solution, a hot-melt adhesive, or a pressure-sensitive adhesive tape. In some embodiments, the thermal interface material includes a material comprising of aluminum oxide, boron nitride, zinc oxide, and/or aluminum nitride. In some embodiments, the filler module includes a material comprising graphite, copper, aluminum, silver, gold, aluminum alloy, diamond, copper-tungsten pseudo-alloy, silicon carbide in aluminum matrix (e.g., AlSiC), diamond in copper-silver alloy matrix (e.g., Dymalloy), and/or beryllium oxide in beryllium matrix.

In some embodiments, the thermal interface material completely fills an interface gap between the at least one heat producing components of the circuit board and the filler module.

In some embodiments, the base structure of the filler module includes a thermal contact surface spanning an overlaid portion of the filler module over the circuit board, the contact surface being configured to receive a plurality of configurations of the thermal interface material, including a first configuration and second configuration (e.g., differing sizes, thicknesses, and location).

In some embodiments, the system further includes a second circuit board (e.g., a daughter card) operatively connected to one of the one or more mezzanine sites (e.g., of a carrier board or single board computer configured with at least two mezzanine sites), wherein the second circuit board is coupled to a second base structure (e.g., a heat spreader and/or heat sink of the daughter card) so as to form a direct thermal conduction path therewith, and wherein the base structure of the filler module (e.g., the filler module) is proximately positionable with respect to the second circuit board so as to form a thermal conduction path therewith (e.g., wherein the thermal conduction path comprise either i) a direct thermal contact between the base structure and the second base structure or ii) thermal flow across a thermal interface material applied between the base structure of the filler module and the second base structure of the second circuit board). Heat sink refers to discrete heat sink components as well as bus bars, active transport components (e.g., fluid circulation blocks), and/or chassis cabinets to which the system is mounted.

In some embodiments, the system further includes a heatframe coupled to the circuit board so as to make direct thermal contact with a heat producing component of the one or more heat producing components of the circuit board (e.g., wherein the heatframe includes i) a side rail configured to provide a heat path for removing heat from the circuit board or ii) a central bar member configured to provide a heat path for removing heat from the circuit board), wherein, when the filler module is proximately positioned with respect to the one or more heat producing components, the filler module forms a direct thermal conduction path with the heatframe.

In some embodiments, the one heat producing component is an integrated circuit, a processing module (e.g., a CPU), a graphic processing module (e.g., a GPU), a host bridge module (e.g., Northbridge IC), a peripheral bridge module (e.g., a Southbridge IC), a network module, a chipset, a graphics card, a memory module, or a storage module (e.g., a hard disk drive, a Flash disk, a CompactFlash Disk).

In some embodiments, the filler module includes one or more fins (e.g., wherein the fins are configured such that, when the filler module is proximately positioned with respect to the circuit board, each of one or more fins of the module member aligns with respective one or more fins associated with the circuit board so as to form a channel).

In some embodiments, a portion of the filler module is hollow.

In some embodiments, the filler module is solid.

In some embodiments, the filler module includes at least one interface selected from the group consisting of a screw, a thermally conductive tape or epoxy, a wire-form z-clip, a flat-spring clip, a stand-off spacer, and a push pin, to be removably connectable with the at least one mounting member of the circuit board.

In some embodiments, the mezzanine site includes a site for coupling a daughterboard to the circuit board such that the daughterboard overlaps (e.g., above or below) with a surface of the circuit board.

In some embodiments, the system further includes a faceplate fixably coupled to a front side of the circuit board (e.g., a carrier board or single board computer), the faceplate having a first thickness, wherein the base structure of the filler module has a second thickness such that the base structure and the circuit board collectively forms the first thickness when the base structure is proximately positionable with respect to the circuit board (e.g., wherein the surface of the base structure are flushed with a side wall of the faceplate when the filler module is assembled on the circuit board).

In some embodiments the system includes a second device selected from the group consisting of a PCI Mezzanine Card (PMC), a PCIe PMC (PMC-X), a Processor PMC (PPMC or PrPMC), a conduction-cooled PMC (CCPMC), a Switched Mezzanine Card (XMC), and a FPGA Mezzanine Card (FMC), wherein the filler module has a surface proximately positionable with respect to the second device so as to form a thermal conduction path therewith. In some embodiments second device conforms to at least one standard selected from the group consisting of IEEE P1386.1, ANSI/VITA 20-2001, and VITA 42.0 (e.g., wherein the filler module conforms to the at least one standard selected from the group consisting of IEEE P1386.1, ANSI/VITA 20-2001, and VITA 42.0).

In some embodiments the filler module has a width spanning, at least, a width of one of the one or more the mezzanine sites. In some embodiments, the filler module spans a part of the mezzanine site, the width of the mezzanine site, or a width greater than the mezzanine site.

In some embodiments, the system further includes a heat pipe and/or a vapor chamber, wherein the heat pipe and/or vapor chamber has a surface proximately positionable with respect to the one of the at least one heat producing component so as to form a thermal conduction path therewith, and wherein the filler module forms a thermal conduction path with the heat pipe and/or vapor chamber when the filler module is proximately positioned with respect to the circuit board.

In another aspect, an apparatus (e.g., a filler module) is disclosed. The apparatus includes a base structure (e.g., the heat sink / heat spreading portion of the filler module); and one or more mounting members (e.g., standoffs, spacers, DIN connectors) fixably coupled to the base structure, wherein the one or more mounting members are removably attachable to one or more corresponding mounting members of a computing module (e.g., a carrier board or single board computer) to comprise a mounting configuration for the apparatus and the computing module, wherein, in the mounting configuration, a surface of the base structure is proximately positioned to form a thermal conduction path with one or more electrical components mounted to a circuit board of the computing module (e.g., wherein the computing module is to operatively couple to one or more second computing modules at the corresponding mounting members) (e.g., wherein the second computing device comprises a single board computer or a carrier board).

In some embodiments, the apparatus includes a base structure having a surface proximately positionable with respect to one of one or more heat producing components of the circuit board so as to form a thermal conduction path therewith (e.g., i) direct thermal contact between the filler module and ICs on the PCB, or ii) across a thermal interface material applied between the one of one or more heat producing components of the circuit board and the base structure of the filler module).

In some embodiments, the base structure of the filler module includes a thermal contact surface spanning an overlaid portion of the filler module over the circuit board, the contact surface being proximately positionable to a plurality of circuit board of a plurality of module computing devices (e.g., single board computer), including a first computing device and a second computing device, the first computing device having a first set of plurality of heat producing components at a first placement configuration on the circuit board thereof, and the second computing device having a second set of plurality of heat producing components at a second placement configuration on the circuit board thereof, wherein the first placement configuration is different from the second placement configuration.

In some embodiments, the base structure of the filler module is proximal, when in the assembled configuration with a given circuit board, to only heat producing components of the given circuit board so as to only form a thermal conduction path therewith (e.g., wherein the filler module negligibly generates heat therein, e.g., does not include a CPU, memory module).

In some embodiments, the mounting members of the filler module are either i) fixably connected to the base structure of the filler module or ii) fixably connected to a circuit board of the filler module, the circuit board of the filler module being fixably coupled to the base structure of the filler module.

In some embodiments, the apparatus includes a thermal interface material (TIM) applied between two or more the at least one heat producing component and the base structure so as to form direct thermal contact therebetween. In some embodiments, the thermal interface material is selected based on a contact pressure property, an electrical resistivity property, or a dielectric strength property. In some embodiments, the thermal interface material includes thermal grease, e.g., epoxy, a silicone, a urethane, and an acrylate. In some embodiments, the thermal interface material includes a material comprising a solvent-based solution, a hot-melt adhesive, and/or a pressure-sensitive adhesive tape. In some embodiments, the thermal interface material includes a material comprising aluminum oxide, boron nitride, zinc oxide, and/or aluminum nitride. In some embodiments, the filler module includes a material comprising graphite, copper, aluminum, silver, gold, aluminum alloy, diamond, copper-tungsten pseudo-alloy, silicon carbide in aluminum matrix (e.g., AlSiC), diamond in copper-silver alloy matrix (e.g., Dymalloy), and/or beryllium oxide in beryllium matrix. In some embodiments, the thermal interface material completely fills an interface gap between i) the at least one heat producing components of the circuit board and ii) the filler module.

In some embodiments, the base structure of the filler module includes a thermal contact surface spanning an overlaid portion of the filler module over the circuit board, the contact surface being configured to receive a plurality of configurations of the thermal interface material, including a first configuration and second configuration (e.g., differing sizes, thicknesses, and location).

In some embodiments, when the apparatus is proximately positioned with respect to the one or more heat producing components, the apparatus forms a direct thermal conduction path with a heatframe.

In some embodiments, the one heat producing component is an integrated circuit, a processing module (e.g., a CPU), a graphic processing module (e.g., a GPU), a host bridge module (e.g., Northbridge IC), a peripheral bridge module (e.g., a Southbridge IC), a network module, a chipset, a graphics card, a memory module, or a storage module (e.g., a hard disk drive, a Flash disk, a CompactFlash Disk).

In some embodiments, the apparatus includes one or more fins (e.g., wherein the fins are configured such that, when the filler module is proximately positioned with respect to the circuit board, each of one or more fins of the module member aligns with respective one or more fins associated with the circuit board so as to form a channel).

In some embodiments, a portion of the apparatus is hollow.

In some embodiments, the apparatus is solid.

In some embodiments, the apparatus includes at least one interface selected from the group consisting of a screw, a thermally conductive tape or epoxy, a wire-form z-clip, a flat-spring clip, a stand-off spacer, and a push pin, to be removably connectable with the at least one mounting member of the circuit board.

In some embodiments, the mezzanine site includes a site for coupling a daughterboard to the circuit board such that the daughterboard overlaps (e.g., above or below) with a surface of the circuit board.

In some embodiments, the base structure has a thickness such that the base structure and the circuit board collectively forms a first thickness defining a front face of the circuit board when the base structure is proximately positionable with respect to the circuit board (e.g., wherein the surface of the base structure are flushed with a side wall of the faceplate when the filler module is assembled on the circuit board).

In some embodiments the apparatus has a surface proximately positionable with respect to a second device (e.g., a daughter card) so as to form a thermal conduction path therewith. In some embodiments second device conforms to at least one standard selected from the group consisting of IEEE P1386.1, ANSI/VITA 20-2001, and VITA 42.0 (e.g., wherein the filler module conforms to the at least one standard selected from the group consisting of IEEE P1386.1, ANSI/VITA 20-2001, and VITA 42.0).

In some embodiments the apparatus has a width spanning, at least, a width of one of the one or more the mezzanine sites. In some embodiments, the apparatus spans a part of the mezzanine site, the width of the mezzanine site, or a width greater than the mezzanine site. In some embodiments, the apparatus forms a thermal conduction path with the heat pipe and/or vapor chamber when the filler module is proximately positioned with respect to the circuit board.

In another aspect, a method (e.g., for the regulation of device temperature) is described. The method includes providing a computing module comprising a circuit board (e.g., a printed circuit board such as a carrier card or single board computer), the circuit board including one or more mezzanine site (e.g., an area on the PCB designated for a second circuit board (e.g., a printed circuit board)) such that the second circuit board overlays one or more components of the plurality of heat producing components of the first circuit board) and a first set of one or more mounting members (e.g., for coupling to the second circuit board). The method further includes positioning a module member with respect to the computing module (e.g., at a mezzanine site of the computing module) so that a second set of one or more mounting members (e.g., IO connectors) of the module member communicatively connects to the first set of one or more mounting members of the computing module, wherein the connection results in a base structure of the module member being in proximity to one or more electrical components mounted on the computing module. The method further includes energizing the computing module, wherein heat generated from each of the one or more energized electrical components is channeled from the respective electrical component to the base structure of the module member along a thermal conduction path.

In some embodiments, the heat generated from each of the one or more energized electrical components is channeled from the respective electrical component to the base structure of the module member along a thermal conduction path across a thermal interface layer, wherein the thermal interface layer is applied between the base structure of the filler module and the each respective electrical component in communication therewith.

### BRIEF DESCRIPTION OF THE DRAWINGS

The components in the drawings are not necessarily to scale relative to each other and like reference numerals designate corresponding parts throughout the several views:
Fig. 1 depicts an example computing device configured with mezzanine sites to receive a mezzanine filler module in accordance with an illustrative embodiment.
Fig. 2, comprising of Fig. 2A and 2B, depicts an exemplary mezzanine-based filler module (Fig. 2A) and the same filler module installed onto the computing device of Fig. 1 (Fig. 2B).
Fig. 3, comprising of Fig. 3A and 3B, depicts an exemplary mezzanine-based filler module in communication with a thermal interface material in accordance with an illustrative embodiment.
Fig. 4 depicts an exemplary mezzanine-based filler module configured with passive cooling topology in accordance with an illustrative embodiment.
Fig. 5, comprising Figs 5A and 5B, shows photographs of an exemplary mezzanine-based filler module with passive cooling topology in accordance with an illustrative embodiment.
Fig. 6 is a block diagram illustrating a method of thermal regulation using a mezzanine-based filler module in accordance with an illustrative embodiment.

### DETAILED DESCRIPTION

Unless defined otherwise, all technical and scientific terms used herein have the same meaning as commonly understood by one of ordinary skill in the art. Methods and materials similar or equivalent to those described herein can be used in the practice or testing of the present disclosure.

As used in the specification and the appended claims, the singular forms "a," "an" and "the" include plural referents unless the context clearly dictates otherwise. Ranges may be expressed herein as from "about" one particular value, and/or to "about" another particular value. When such a range is expressed, another embodiment includes from the one particular value and/or to the other particular value. Similarly, when values are expressed as approximations, by use of the antecedent "about," it will be understoodthat the particular value forms another embodiment. It will be further understood that the endpoints of each of the ranges are significant both in relation to the other endpoint, and independently of the other endpoint.

"Optional" or "optionally" means that the subsequently described event or circumstance may or may not occur, and that the description includes instances where said event or circumstance occurs and instances where it does not.

Throughout the description and claims of this specification, the word "comprise" and variations of the word, such as "comprising" and "comprises," means "including but not limited to," and is not intended to exclude, for example, other additives, components, integers or steps. "Exemplary" means "an example of" and is not intended to convey an indication of a preferred or ideal embodiment. "Such as" is not used in a restrictive sense, but for explanatory purposes.

Disclosed are components that can be used to perform the disclosed methods and systems. These and other components are disclosed herein, and it is understood that when combinations, subsets, interactions, groups, etc. of these components are disclosed that while specific reference of each various individual and collective combinations and permutation of these may not be explicitly disclosed, each is specifically contemplated and described herein, for all methods and systems. This applies to all aspects of this application including, but not limited to, steps in disclosed methods. Thus, if there are a variety of additional steps that can be performed it is understood that each of these additional steps can be performed with any specific embodiment or combination of embodiments of the disclosed methods.

The present methods and systems may be understood more readily by reference to the following detailed description of preferred embodiments and the Examples included therein and to the Figures and their previous and following description.

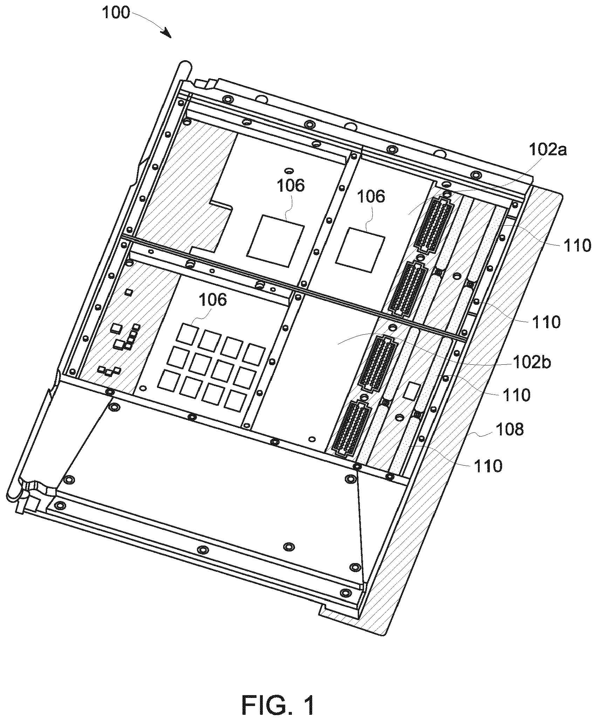

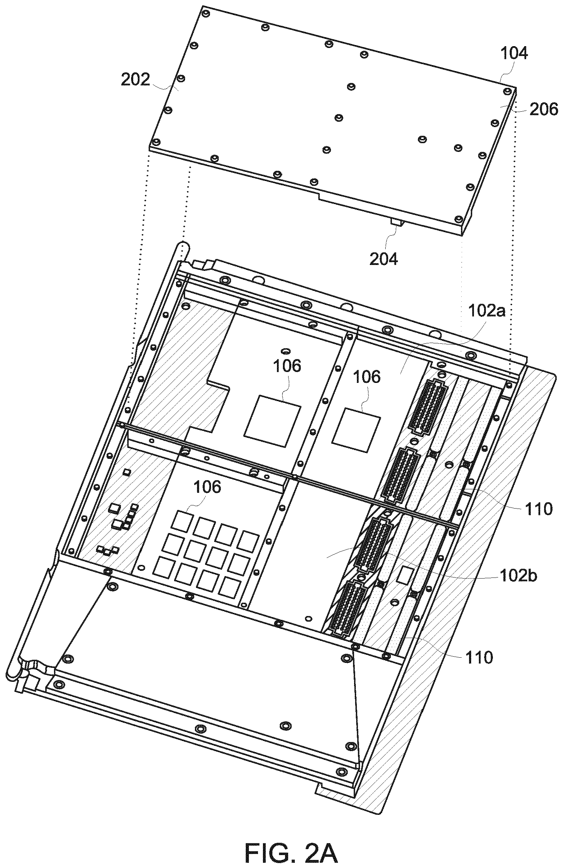

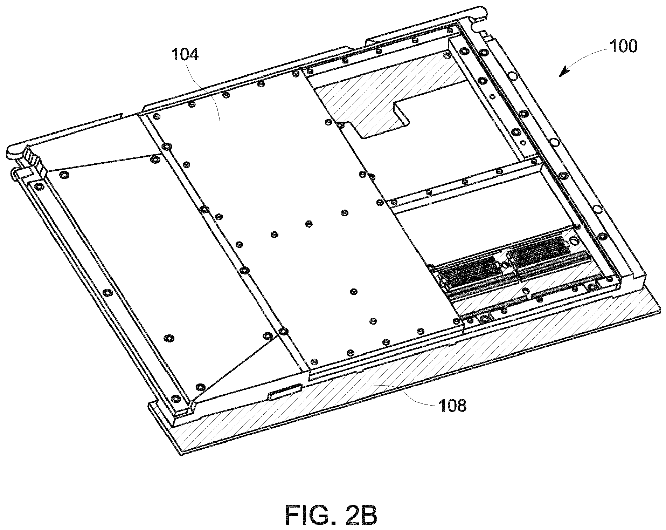

Fig. 1 depicts an example computing device 100 configured with mezzanine sites 102 to receive a mezzanine filler module 104 (not shown - see Fig. 2) in accordance with an illustrative embodiment. The computing device 100 includes a plurality of heat generating components 106 (shown in Fig. 1 as outlines beneath a heatframe), including one or more processor ICs, one or more memory ICs, one or more chipset ICs, some of which are located at the mezzanine site 102 such that the components overlay with a daughterboard card when the card is connected to the main board 100. The computing device 100 shown is a 6U form factor device, though other form factors such as, but not limited to, 1U, 3U, 6U, 9U may be used with a mezzanine filler module disclosed herein.

The computing device 100 includes two mezzanine sites 102 (shown as mezzanine site #1 (102a) and mezzanine site #2 (102b)), defined within a region of a circuit board 108 of the computing device 100. The region is reserved for a daughter card (not shown), for example, a second computing device, a peripheral card, a network card, etc. The mezzanine site 102 includes a connector 110 configured to receive and connect to the daughter board at each mezzanine site 102. In some embodiments, the one or more connectors 110 includes connections 112 to the data bus of the computing device 100, as well as connections for IO connectivity, power, ground, and connectors located on the computing device.

Fig. 2, comprising of Fig. 2A and 2B, depicts an exemplary mezzanine filler module 104 installed onto the computing device of Fig. 1. Referring to Fig. 2A, the mezzanine filler module 104 includes abase structure 202 positionable relative to the computing device 100 so as to allow thermal conduction with component of the computing device 100. The mezzanine filler module 104 spans the width of a mezzanine site (e.g., 102a or 102b) and volumetrically fills a substantial volume of the mezzanine site 102. The base structure 202 can be hollow in certain regions. As example of a mezzanine filler module installed in a mezzanine site is shown in Fig. 2B. The base structure includes a surface proximately positionable with respect to one of one or more heat producing components of the circuit board of the computing device so as to form a thermal conduction path therewith. The surface is proximately positionable, for example, when direct thermal contact is formed so as to allow thermal conduction between the filler module and ICs on the circuit board, or across a thermal interface material applied between the filler module and ICs on the circuit board.

In some embodiments, the base structure 202 spans the length of the mezzanine site. In other embodiments, the base structure 202 has a length that partially, though substantially (e.g., greater than 50 percent), overlaps with the mezzanine site. The base structure 202 is preferably thermally conductive to serve as an additional thermal path to assist with the thermal regulation of the computing device. In particular, the base structure 202 provides an additional thermal path for the thermal regulation of components 106 (e.g., heat-generating ICs and chipsets and well as heatsinks and/or heat spreaders) located under the mezzanine site 102. In some embodiments, the mezzanine filler module 104 fills the space of the mezzanine site so as to contact nearby components such as heat-generating components and/or thermal conduction paths in or near the mezzanine site of the computing device to provide an additional heat path to draw thermal energy away from the components and structure, allowing for improved thermal regulation of existing computing devices or the accommodation of higher power usage on new classes of computing devices.

In essence, the mezzanine filler module may be characterized as a thermal spreader and/or thermal sink where a thermal sink is preferably a passive heat exchanger that provide substantial thermal mass for the transference of heat generated by the electronic or a mechanical device of the computing device into a thermal reservoir. The transferred thermal energy can then leave the device with the fluid in motion, or via conduction to the second thermal mass, therefore allowing the regulation of the device temperature. A heat sink can be an active system that uses energy to assisting the transfer of thermal energy, for example, but not limited to, a mechanical fan, a recirculation loop, a heat pipe, among others. A thermal spreader is a heat exchanger that moves heat between a heat source and a secondary heat exchanger whose surface area and geometry are more favorable than the source. The thermal energy is thus spread out over the geometry of the heat exchanger, so that the secondary heat exchanger may be more fully utilized.

Still referring to Fig. 2, the base structure 202 includes connectors 204 to connect to at least one corresponding connectors 110 of the computing device 100. In some embodiments, the connectors 204 include spacer and standoff to releasably couple to the circuit board 108. The base structure 202 is preferably constructed of aluminum or aluminum-based alloy, though other suitable thermal conducting materials such graphite, copper, copper-based alloys, copper-tungsten pseudo-alloys, magnesium, silicon carbide in aluminum matrix (e.g., AlSiC), diamond in copper-silver alloy matrix (e.g., Dymalloy), and beryllium oxide in beryllium matrix) maybe used.

In some embodiments, the base structure of the mezzanine filler module includes mounting structure to external passive or active heat sink, heat spreader, and heat transport devices. For example, the base structure may connect to a bus bar. In another example, the base structure may connect to a chassis (e.g., of a control cabinet). In another example, the base structure may couple to one or more discrete heat sinks with fins. In another example, the base structure may couple to a fluid circulation system (e.g., water or oil recirculation loop). The coupling may be via direct contact or through an intermediate interface material.

In some embodiments, the mezzanine filler module 104 includes a connector (e.g., standoff, spacers, and/or dual in-lin (DIN) connectors) for each connectors of the computing device. In some embodiments, the mezzanine filler module includes two or more connectors to couple to several of the connectors of the computing device. In some embodiment, the mezzanine filler module includes one or more connectors to couple to corresponding one or more connectors on the computing device. The mezzanine filler module couples to the computing device at the mezzanine site preferably in a stacking manner such that the surfaces of the mezzanine filler module are paralleled, or substantially paralleled, to surfaces of the circuit board of the computing device and such that the connectors of the mezzanine filler module and the computing device are flushed to one another. In some embodiments, the mezzanine filler module couples to the computing device such that the surface of the mezzanine filler module is non-paralleled to the surfaces of the circuit board.

In some embodiments, the mezzanine filler module includes one or more mounting standoffs (or a mounting feature to receive a standoff) that positionably aligns to the mounting features on the computing device. Referring to Fig. 2A, the mezzanine filler module includes mounting holes 206 that positionably aligns to mounting holes of the computing device 100 when the filler module 104 is mounted thereon. The mounting holes may conform to one or more form factor standards to allow placement of the mezzanine filler module to any of those standard-compliant computing devices. Examples of other mounting features of the mezzanine filler module include, but not be limited to, thermally conductive tape or epoxy, wire-form z-clips, flat spring clips, standoff spacers, and push pins with ends that expand after installation.

In some embodiments, the module connector 204 of the mezzanine filler module couples to the base structure 202 and terminates thereon. In some embodiments, the pins of the mezzanine connectors of the computing device do not form electrical connection with the module connector 204 of the mezzanine filler module. In other embodiments, the pins of the mezzanine connectors of the computing device terminates at the module connector 204 of the mezzanine filler module such that the pins contacts a structure of the module to allow for thermal conduction, while not forming an electrical connection. In other embodiments, the mezzanine connectors connects to circuitries and/or sensors (not shown) embedded on or within the base structure 202 of the mezzanine filler module. The circuitries and/or sensors may provide thermal measurement, alignment readings, and/or module placement at, for example, but not limited to, one or more locations of the bases structure of the mezzanine filler module.

The mezzanine filler module 104 is preferably dimensioned to conform one or more industrial, military, or aerospace standards. In some embodiments, the mezzanine filler module conforms to a standard PCI mezzanine board (PMC) or a Switch mezzanine board (XMC) that includes a serial fabric interconnect defined by the VITA 42 standard. In some embodiments, the mezzanine filler module 104 is manufactured and designed according to IEEE P1386.1, standard, which is wholly incorporated by reference herein. In some embodiments, the mezzanine filler module 104 conforms to the ANSI/VITA 20-2001 standard as described in "ANSI/VITA 20-2001 (R2011)" by the American National Standard, Inc. February 2011, wholly incorporated by reference herein. In some embodiments, the mezzanine filler module 104 conforms to the VITA 42.0 XMC standard as described in "Standard for VITA 42.0 XMC", by the American National Standards Institute, Inc. December 2008, wholly incorporated by reference herein.

The mezzanine filler module may conform to other standards and form factor such as, but not limited to, PCI-express mezzanine board (PMC-X), a Processor mezzanine board (PPMC or PrPMC), a conduction-cooled mezzanine board (CCPMC), and a field-programmable-gate-array mezzanine card (FMC).

In some embodiments, the mezzanine filler module includes a circuit board that collectively forms the base structure with a bulk base structure (e.g., a heatblock, heat sink, and/or heat spreader) mounted thereon. The circuit board may or may not be populated with ICs or functional electrical components and is used to provide surfaces to mount the bulk base structure, the module connectors, and mounting features of the mezzanine filler board discussed herein.

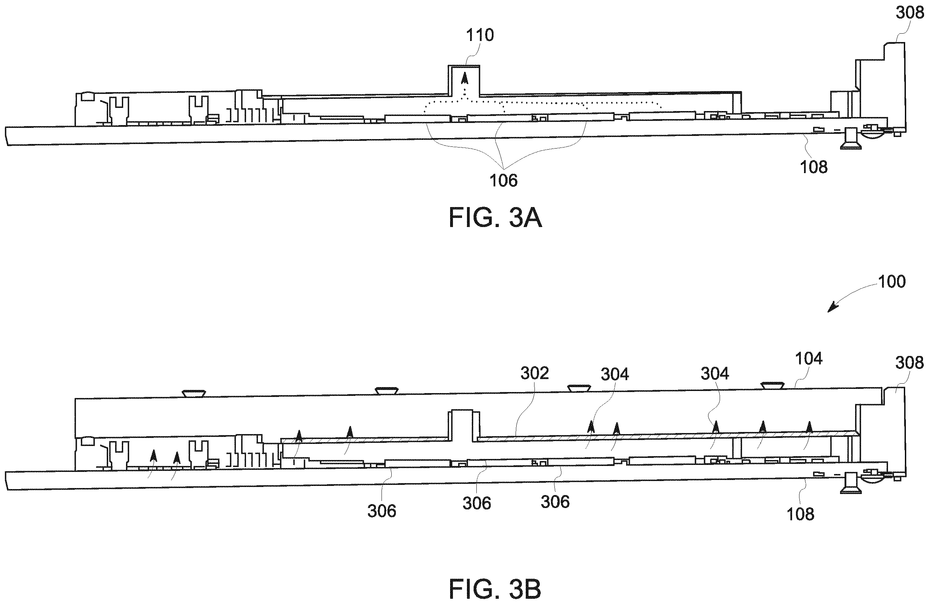

Fig. 3, comprising of Fig. 3A and 3B, depicts an exemplary mezzanine filler module 104 in communication with a thermal interface material 302 in accordance with an illustrative embodiment. Fig. 3A depicts the side view of a single board computer that includes a circuit board 108 populated with heat generating components 106. The thermal interface material 302 improves thermal conduction between the mezzanine filler module 104 and heat-generating components 106 of the computing device 100 by providing additional thermal conductions paths between them. The thermal interface material 302 allows for mezzanine filler module 104 to be positioned proximal to the circuit board 108 without making direct contact with the components (e.g., IC and other mechanical features) thereon.

The thermal interface material 302 provides a flexible interface (in that it can be placed at multiple locations on a surface of the mezzanine filler module facing the circuit board) to allow thermal conduction between the filler module and the circuit board including the ICs and components thereon. Because the mezzanine filler module conforms, in some embodiments, to the dimensions of the mezzanine site, the mezzanine filler module is retrofit-able to any computing device that includes a mezzanine site. In some embodiments, the location and type of the thermal interface material can be customizably selected for a specific application and/or group of devices.

Referring still to Fig. 3, the thermal filler material 302 is applied between the mezzanine filler module 104 and the circuit board 108, and the heat generating components 106 thereon, of the computing device such that a thermal conduction path 304 forms therebetween. As shown, a thermal conduction path 304 is formed between each of the IC components 306 populated in the mezzanine site 102 of the computing device 100. The mezzanine filler module 104 fills the volume of the mezzanine site 102 as defined by the faceplate 308 of the computing device 100.

Without the mezzanine module (as shown in Fig. 3A), thermal energy from the circuit board of the computing device 100 mainly conducts, for example, through the heatframe material of traditional computing devices with mezzanine sites, and where the heatframe is reduced due to the cutouts defining the mezzanine site. With the filler module (Fig. 3B) and thermal interface material, multiple less-restrictive heat paths are formed, allowing for the accommodation of higher heat loads on the circuit board.

The thermal interface material may reduce thermal contact resistance that may exist due to one or more voids created by surface roughness effects, defects and misalignment of the interface between the filler module and the heat producing components and/or the circuit board. The voids present in the interface can be filled with air. Heat transfer can then be due to conduction across the actual contact area and conduction (or natural convection) and radiation across the gaps. If the contact area is small, as it is for rough surfaces, the major contribution to the resistance can be made by the gaps. Properly applied thermal interface material displaces the air that is present in the gaps between objects (for example, the filler module and the PCB) with a material that has a much-higher thermal conductivity. Air can have a thermal conductivity of approximately 0.022 W/m•K while a suitable thermal interface material may have conductivities of approximately 0.3 W/m•K and higher. The selection of the thermal interface material may be based on one or more of the contact pressure, electrical resistivity, or dielectric strength of the TIM material.

In some embodiments, the thermal interface material includes a sheet of deformable material to be applied between the mezzanine filler module and the circuit board of the computing device. The sheet may substantially span (e.g., greater than 50 percent) the underlying contact surface of the mezzanine filler module.

In various aspects, thermal grease, functioning in a similar way as the thermal interface material, are further couple heat between two or more of the heat producing components, the mezzanine filler module, and/or the heatframe of the computing device. Examples of suitable thermal grease include, but not limited to, an epoxy, a silicone, a urethane, and an acrylate. The thermal grease may be a solvent-based system, a hot-melt adhesives, and/or a pressure-sensitive adhesive tape. Hot-melt adhesives and pressure-sensitive adhesive tapes may include an aluminum oxide filler, a boron nitride filler, a zinc oxide filler, and an aluminum nitride filler.

In some embodiments, the mezzanine filler module is retrofit-able to one or more standard PMC and/or XMC mezzanine sites. This may allow on-board heat-producing components to operate closer to their maximum performance operational points. In some embodiments, the mezzanine filler module may prevent the necessity of designing custom heatsinks, head spreaders, and/or heatframes for the incorporation of PMC/XMC mezzanine site(s). Additional consideration for retrofitting the filler module can be the selection and location of the thermal interface material, which may depend on one or more of the previously mentioned factors. In other aspects, the mezzanine filler module may assist in the fulfillment of various mechanical requirements such as reducing effects from shocks and vibrations subjected onto the computing device.

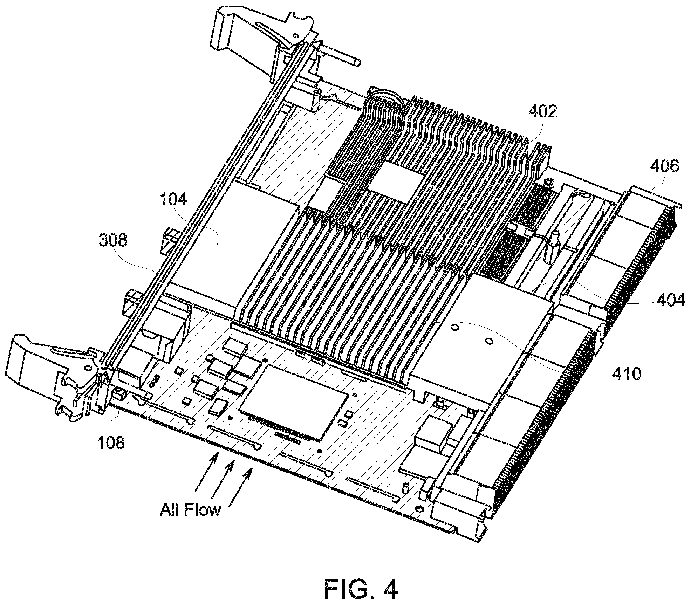

In another aspect, the mezzanine filler module 104 may include passive and/or active components located on its base structure to assist in the thermal regulation of the computing device 100. Fig. 4 depicts an exemplary mezzanine-based filler module configured with passive cooling topology exemplified as fins in accordance with an illustrative embodiment. The passive cooling topology may be located on a mounting surface of the mezzanine filler module (e.g., of the base structure) and that mates with a corresponding mounting surface of components (shown as heat sink 402) mounted to the computing device to draw thermal energy therefrom. The cooling topology may align with surface topology on components of the computing device so as to form cooling channels. In some embodiments, the base structure contacts heat-sink or heat spreading components of the computing device. In some embodiments, the shape of fins 410 is optimized to maximize heat transfer density and to minimize the pressure drop in the coolant fluid across the base structure of the mezzanine filler module. In some embodiments, the fins are shaped as elliptical and/or cylindrical structures. In other embodiments, the fins are shaped as cones, rhombus, or square. In some embodiments, the fins include pin fins, which may be cylindrical, elliptical, or square. In some embodiments, the fins may form straight structure that extends along the entire width of the mezzanine filler module.

The base structure of the mezzanine filler module, in some embodiments, has a greater surface area than corresponding surface areas of components of the computing device to which they mate. As shown in Fig. 4, the contact surface area 404 of the mezzanine filler module extends along the length and width of the mezzanine site 102 to provide a cross-sectional area that spans such length. In contrast, the heatsink of the component 402 of the computing device may extend only a portion of the length of the base structure of the mezzanine filler module.

The length of the mezzanine site 102 may span between the faceplate 308 and a backplane connector 406 mounted to the circuit board of the computing device.

In some embodiments, the mezzanine filler module includes a heat pipe integrated into the base structure. The heat pipe as a heat-transfer device provides both thermal conductivity and phase transition to regulate the transfer of heat between two solid interfaces. In some embodiments, the mezzanine module includes a thin planar heat pipe, also known as a flat heat pipe or a vapor chamber. In some embodiments, the mezzanine filler module includes a variable conductance heat pipes (VCHPs) integrated into the base structure. In some embodiments, the mezzanine filler module includes diode heat pipes. In some embodiments, the mezzanine filler module includes thermosyphons. In some embodiments, the mezzanine filler module includes a loop heat pipe (LHP) integrated into the base structure.

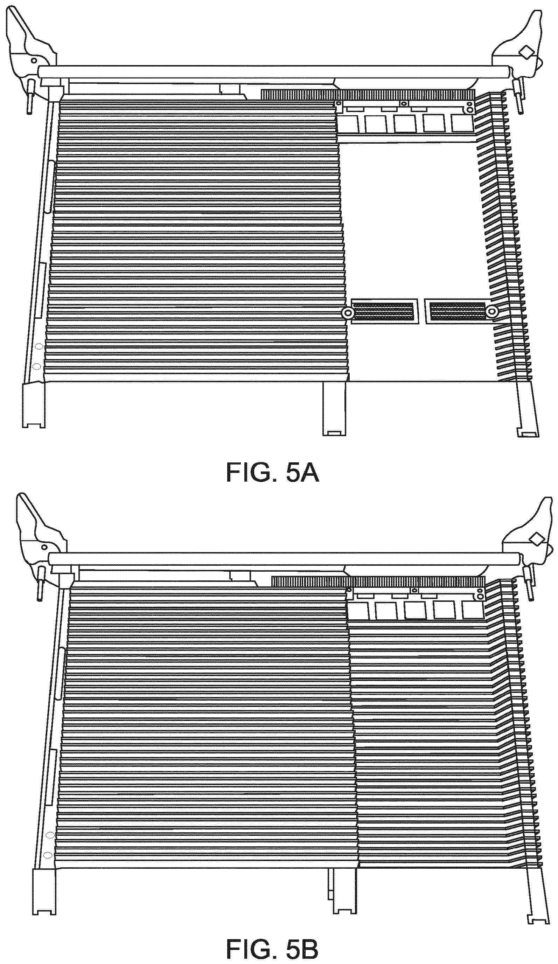

Fig. 5, comprising Figs 5A and 5B, shows photographs of an exemplary mezzanine-based filler module with passive cooling topology in accordance with an illustrative embodiment.

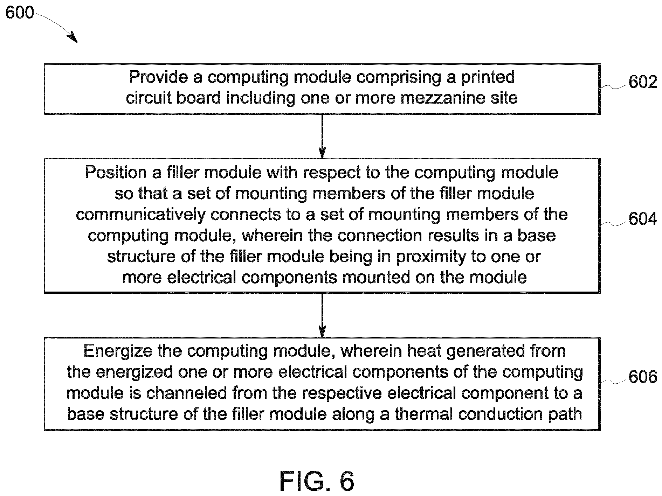

Fig. 6 is a block diagram illustrating a method 600 of thermal regulation using a mezzanine-based filler module in accordance with an illustrative embodiment. The method 600 includes providing a computing module 100 which includes a circuit board (e.g., a carrier card or single board computer) (step 602). The circuit board may include one or more mezzanine site 102 (e.g., an area on the PCB designated for a second circuit board such that the second circuit board overlays one or more components of the plurality of heat producing components of the first circuit board) and a first set of one or more mounting members (e.g., for coupling to the second circuit board).

The method further includes positioning a mezzanine filler module with respect to the computing module (e.g., at a mezzanine site of the computing module) so that a second set of one or more mounting members (e.g., IO connectors) of the filler module communicatively connects to the first set of one or more mounting members of the computing module, wherein the connection results in a base structure of the filler module being in proximity to one or more electrical components mounted on the module member (step 604). The mezzanine filler module collectively forms a computing system with the computing module.

The method further includes energizing the computing module, wherein heat generated from each of the one or more energized electrical components is channeled from the respective electrical component to the base structure of the filler module along a thermal conduction path (step 606). In some embodiments, the heat is channels to an external heat sink (e.g., a chassis frame) or heat spreader coupled to the computing system.

While the methods and systems have been described in connection with preferred embodiments and specific examples, it is not intended that the scope be limited to the particular embodiments set forth, as the embodiments herein are intended in all respects to be illustrative rather than restrictive.

In various aspects of the disclosure, a mezzanine filler module can be used in conjunction with a single board computer (SBC) within military and aerospace applications.

In many devices, such as computers, various heat producing components can be connected to a PCB. Such heat producing components can include a central processing unit (CPU), a Northbridge, multiple memory devices, metal-oxide-semiconductor field-effect transistors (MOSFETs), power circuits, field programmable gate arrays (FPGA), chipsets, graphics cards, hard disk drives, and the like. These components can be susceptible to temporary malfunction or permanent failure if overheated.

Unless otherwise expressly stated, it is in no way intended that any method set forth herein be construed as requiring that its steps be performed in a specific order. Accordingly, where a method claim does not actually recite an order to be followed by its steps or it is not otherwise specifically stated in the claims or descriptions that the steps are to be limited to a specific order, it is no way intended that an order be inferred, in any respect. This holds for any possible non-express basis for interpretation, including: matters of logic with respect to arrangement of steps or operational flow; plain meaning derived from grammatical organization or punctuation; the number or type of embodiments described in the specification.

Throughout this application, various publications may be referenced. The disclosures of these publications in their entireties are hereby incorporated by reference into this application in order to more fully describe the state of the art to which the methods and systems pertain.

It will be apparent to those skilled in the art that various modifications and variations can be made without departing from the scope or spirit. Other embodiments will be apparent to those skilled in the art from consideration of the specification and practice disclosed herein. It is intended that the specification and examples be considered as exemplary only, with a true scope and spirit being indicated by the following claims.

Various aspects and embodiments of the present invention are defined by the following numbered clauses:
1. A system comprising:
   a circuit board including one or more mezzanine sites, each site comprising an area on the circuit board designated for a second circuit board such that the second circuit board overlays one or more components of the plurality of heat producing components of the first circuit board, and one or more mounting members, each of the one or more mounting members being associated with a mezzanine site of the one or more mezzanine sites; and
      a filler module configured to connect to the circuit board at one of the one or more mezzanine sites.
2. The system of clause 1, wherein the filler module comprises abase structure having a surface proximately positionable with respect to one of one or more heat producing components of the circuit board so as to form a thermal conduction path therewith.
3. The system of clause 1 or clause 2, wherein the base structure of the filler module comprises a thermal contact surface spanning an overlaid portion of the filler module over the circuit board, the contact surface being proximately positionable to a plurality of circuit board of a plurality of module computing devices, including a first computing device and a second computing device, the first computing device having a first set of plurality of heat producing components at a first placement configuration on the circuit board thereof, and the second computing device having a second set of plurality of heat producing components at a second placement configuration on the circuit board thereof, wherein the first placement configuration is different from the second placement configuration.
4. The system of any preceding clause, wherein the base structure of the filler module is proximal, when in the assembled configuration with a given circuit board, to only heat producing components of the given circuit board so as to only form a thermal conduction path therewith.
5. The system of any preceding clause, wherein the filler module comprises corresponding mounting members removably connectable with the one or more mounting members of the circuit board.
6. The system of any preceding clause, comprising:
   a thermal interface material (TIM) applied between two or more the at least one heat producing component and the filler module so as to form direct thermal contact therebetween.
7. The system of any preceding clause, wherein the thermal interface material completely fills an interface gap between i) the at least one heat producing components of the circuit board and ii) the filler module.
8. The system of any preceding clause, wherein the base structure of the filler module comprises a thermal contact surface spanning an overlaid portion of the filler module over the circuit board, the contact surface being configured to receive a plurality of configurations of the thermal interface material, including a first configuration and second configuration.
9. The system of any preceding clause, comprising:
   a second circuit board operatively connected to one of the one or more mezzanine sites, wherein the second circuit board is coupled to a second base structure so as to form a direct thermal conduction path therewith, and wherein the base structure of the filler module is proximately positionable with respect to the second circuit board so as to form a thermal conduction path therewith.
10. The system of any preceding clause, comprising:
   a heatframe coupled to the circuit board so as to make direct thermal contact with a heat producing component of the one or more heat producing components of the circuit board, wherein, when the filler module is proximately positioned with respect to the one or more heat producing components, the filler module forms a direct thermal conduction path with the heatframe.
11. The system of any preceding clause, wherein the filler module comprises one or more fins.
12. The system of any preceding clause, wherein a portion of the filler module is hollow.
13. The system of any preceding clause, wherein a portion of the filler module is solid.
14. The system of any preceding clause, wherein the filler module comprises at least one interface selected from the group consisting of a screw, a thermally conductive tape or epoxy, a wire-form z-clip, a flat-spring clip, a stand-off spacer, and a push pin, to be removably connectable with the at least one mounting member of the circuit board.
15. The system of any preceding clause, wherein the mezzanine site comprises a site for coupling a daughterboard to the circuit board such that the daughterboard overlaps with a surface of the circuit board.
16. The system of any preceding clause, comprising:
   a faceplate fixably coupled to a front side of the circuit board, the faceplate having a first thickness, wherein the base structure of the filler module has a second thickness such that the base structure and the circuit board collectively forms the first thickness when the base structure is proximately positionable with respect to the circuit board.
17. The system of any preceding clause, wherein the filler module has a width spanning, at least, a width of one of the one or more the mezzanine sites.
18. An apparatus comprising:
   a base structure; and
   one or more mounting members fixably coupled to the base structure, wherein the one or more mounting members are removably attachable to one or more corresponding mounting members of a computing module to comprise a mounting configuration for the apparatus and the computing module, wherein, in the mounting configuration, a surface of the base structure is proximately positioned to form a thermal conduction path with one or more electrical components mounted to a circuit board of the computing module.
19. A method for the regulation of device temperature, the method comprising: providing a computing module comprising a circuit board, the circuit board including one or more mezzanine site and a first set of one or more mounting members for coupling to the second circuit board;
   positioning a module member with respect to the computing module so that a second set of one or more mounting members of the module member communicatively connects to the first set of one or more mounting members of the computing module, wherein the connection results in a base structure of the module member being in proximity to one or more electrical components mounted on the computing module; and
   energizing the computing module, wherein heat generated from each of the one or more energized electrical components is channeled from the respective electrical component to the base structure of the module member along a thermal conduction path.
20. The method of clause 19, wherein the heat generated from each of the one or more energized electrical components is channeled from the respective electrical component to the base structure of the module member along a thermal conduction path across a thermal interface layer, wherein the thermal interface layer is applied between the base structure of the module member and the each respective electrical component in communication therewith.

## Claims

1. A system comprising:
a first circuit board (108) including one or more mezzanine sites (102), each site comprising an area on the first circuit board (108) designated for a second circuit board such that the second circuit board overlays one or more components (106) of a plurality of heat producing components of the first circuit board (108), and one or more mounting members, each of the one or more mounting members being associated with a mezzanine site of the one or more mezzanine sites (102); and
a filler module (104) configured to connect to the first circuit board (108) at one of the one or more mezzanine sites (102).

2. The system of claim 1, wherein the filler module (104) comprises a base structure (202) having a surface proximately positionable with respect to one of one or more heat producing components of the first circuit board (108) so as to form a thermal conduction path (304) therewith.

3. The system of claim 1 or claim 2, wherein the base structure (202) of the filler module (104) comprises a thermal contact surface spanning an overlaid portion of the filler module (104) over the first circuit board (108), the contact surface being proximately positionable to a plurality of circuit board of a plurality of module computing devices, including a first computing device (100) and a second computing device, the first computing device (100) having a first set of plurality of heat producing components at a first placement configuration on the first circuit board (108) thereof, and the second computing device having a second set of plurality of heat producing components at a second placement configuration on the second circuit board thereof, wherein the first placement configuration is different from the second placement configuration.

4. The system of any preceding claim, wherein the base structure (202) of the filler module (104) is proximal, when in the assembled configuration with a given circuit board, to only heat producing components of the given circuit board so as to only form a thermal conduction path (304) therewith.

5. The system of any preceding claim, wherein the filler module (104) comprises corresponding mounting members removably connectable with the one or more mounting members of the first circuit board (108).

6. The system of any preceding claim, comprising:
a thermal interface material (TIM) (302) applied between two or more the at least one heat producing component (106) and the filler module (104) so as to form direct thermal contact therebetween, wherein the thermal interface material (302) completely fills an interface gap between i) the at least one heat producing components of the first circuit board (108) and ii) the filler module (104).

7. The system of any preceding claim, wherein the base structure (202) of the filler module (104) comprises a thermal contact surface spanning an overlaid portion of the filler module (104) over the first circuit board (108), the contact surface being configured to receive a plurality of configurations of the thermal interface material (302), including a first configuration and second configuration.

8. The system of any preceding claim, comprising:
a second circuit board operatively connected to one of the one or more mezzanine sites (102), wherein the second circuit board is coupled to a second base structure so as to form a direct thermal conduction path (304) therewith, and wherein the base structure (202) of the filler module (104) is proximately positionable with respect to the second circuit board so as to form a thermal conduction path (304) therewith.

9. The system of any preceding claim, comprising:
a heatframe coupled to the first circuit board (108) so as to make direct thermal contact with a heat producing component of the one or more heat producing components of the first circuit board (108), wherein, when the filler module (104) is proximately positioned with respect to the one or more heat producing components, the filler module (104) forms a direct thermal conduction path (304) with the heatframe.

10. The system of any preceding claim, wherein the filler module (104) comprises one or more of fins and is hollow or at least a portion of the filler module (104) is solid.

11. The system of any preceding claim, wherein the filler module (104) comprises at least one interface selected from the group consisting of a screw, a thermally conductive tape or epoxy, a wire-form z-clip, a flat-spring clip, a stand-off spacer, and a push pin, to be removably connectable with the at least one mounting member of the first circuit board (108).

12. The system of any preceding claim, wherein the mezzanine site (102) comprises a site for coupling a daughterboard to the first circuit board (108) such that the daughterboard overlaps with a surface of the first circuit board (108).

13. The system of any preceding claim, comprising:
a faceplate (308) fixably coupled to a front side of the first circuit board (108), the faceplate (308) having a first thickness, wherein the base structure of the filler module (104) has a second thickness such that the base structure and the first circuit board (108) collectively forms the first thickness when the base structure is proximately positionable with respect to the first circuit board (108).

14. An apparatus comprising:
a base structure (202); and
one or more mounting members fixably coupled to the base structure (202), wherein the one or more mounting members are removably attachable to one or more corresponding mounting members of a computing module (100) to comprise a mounting configuration for the apparatus and the computing module (100), wherein, in the mounting configuration, a surface of the base structure (202) is proximately positioned to form a thermal conduction path (304) with one or more electrical components (106) mounted to a circuit board (108) of the computing module (100).

15. A method for the regulation of device temperature, the method comprising: providing a computing module (100) comprising a circuit board (108), the circuit board (108) including one or more mezzanine sites (102) and a first set of one or more mounting members for coupling to a second circuit board;
positioning a module member (104) with respect to the computing module (100) so that a second set of one or more mounting members of the module member (104) communicatively connects to the first set of one or more mounting members of the computing module (100), wherein the connection results in a base structure (202) of the module member (104) being in proximity to one or more electrical components (106) mounted on the computing module (100); and
energizing the computing module (100), wherein heat generated from each of the one or more energized electrical components (106) is channeled from the respective electrical component to the base structure (202) of the module member (104) along a thermal conduction path (304), wherein the heat generated from each of the one or more energized electrical components (106) is channeled from the respective electrical component to the base structure (202) of the module member (104) along a thermal conduction path (304) across a thermal interface layer (302), and wherein the thermal interface layer (302) is applied between the base structure (202) of the module member (104) and the each respective electrical component (106) in communication therewith.
